# EUROPÄISCHE PATENTSCHRIFT

(11) **EP 4 324 052 B1**
(45) Veröffentlichungstag und Bekanntmachung des Hinweises auf die Patenterteilung: **21.01.2026**
(21) Anmeldenummer: 22721647.0
(22) Anmeldetag: 28.03.2022
(51) Int. Cl.: H01R 9/24, H01R 12/62, H01R 12/67, H01R 12/51, H01R 12/53, H01R 4/2433, H01B 3/00, H01R 4/70, H01R 9/03, H01R 13/405

(54) **KABELANSCHLUSSEINHEIT FÜR EINE ANSCHLUSSDOSE**
CABLE CONNECTION UNIT FOR A CONNECTION BOX
UNITÉ DE JONCTION DE CÂBLE POUR BOÎTE DE JONCTION

(30) Priorität: 14.04.2021 DE 102021109298
(43) Veröffentlichungstag der Anmeldung: 21.02.2024
(73) Patentinhaber: HARTING Electronics GmbH, 32339 Espelkamp (DE)
(72) Erfinder: GENAU, Marc, 32339 Espelkamp (DE); BUSSMANN, Rainer, 32339 Espelkamp (DE)
(86) Internationale Anmeldenummer: PCT/DE2022/100232
(87) Internationale Veröffentlichungsnummer: WO 2022/218465

(56) Entgegenhaltungen:
- EP-A1- 0 734 095
- EP-A1- 2 061 118
- EP-A1- 2 230 728
- DE-A1- 102004 007 525
- DE-A1- 102008 021 868

## Beschreibung

Die Erfindung geht aus von einer Kabelanschlusseinheit nach der Gattung des unabhängigen Anspruchs 1. Die Erfindung bezieht sich weiterhin auf ein System aus einer Anschlussdose und einer solchen Kabelanschlusseinheit und ein Verfahren zum Anschließen der Kabelanschlusseinheit an die Anschlussdose.

Derartige Kabelanschlusseinheiten werden zur elektrischen Kontaktierung von Anschlussdosen eingesetzt. Derartige Anschlussdosen werden insbesondere in der Gebäudeinstallation verwendet und können mit einer elektronischen Steuerung, insbesondere für Stellmotoren von Lüftungsanlagen, ausgestattet sein.

### Stand der Technik

EP 2 230 728 A1 (DE 10 2009 001 656 A1) offenbart ein mehradriges Kabel, ein Elektrogerät und ein Verfahren zum Anschließen eines mehradrigen Kabels an ein Elektrogerät. Das mehradrige elektrische Kabel weist eine Befestigungsvorrichtung mit wenigstens einer Öffnung und einer Oberfläche auf. Das mehradrige Kabel weist ferner mehrere an der Oberfläche der Befestigungsvorrichtung befestigte isolierte Einzeladern auf, die über der wenigstens einen Öffnung verlaufen.

Die DE 10 2008 021 868 A1 zeigt einen elektrischen Verbinder, mit dem ein flexibler Draht oder ein mehradriges Kabel, der/das mit mindestens einem elektrischen Leiter versehen ist, an ein Gegenstück angeschlossen wird, wobei das anzuschließende Draht- oder Kabelende mit mindestens einem mechanischen Teil des Verbinders untrennbar verbunden ist und wobei der Verbinder derart konstruiert ist, dass der/die sich am Ende des Drahts oder Kabels befindliche/n Leiter bei der Montage an das Aggregat oder die Buchse mittels am Gegenstück angeordneter Kontakt elektrisch kontaktiert wird und dabei der Draht oder das Kabel gemeinsam mit dem Verbinder mit dem Aggregat oder dem Sockel elektrisch und mechanisch verbunden wird.

Die DE 10 2004 007 525 A1 zeigt eine Abzweigbox zum nachträglichen Installieren an einer Spannung führenden Netzleitung setzt sich aus zwei Gehäusehälften zusammen. Die wandseitige Gehäusehälfte enthält Zentriereinrichtungen für die isolierten Einzeladern des Netzkabels. Die andere Gehäusehälfte ist mit Steckdosen versehen und enthält in ihrem Inneren einen beweglich geführten Satz von gegeneinander isolierten Schneidklemmkontakten. Bei geschlossenem Gehäuse können die Schneidklemmkontakte von außen über ein Werkzeug mit den Einzeladern in eine stromleitende Verbindung gebracht werden. Solange die stromleitende Verbindung nicht hergestellt ist, verhindert ein Sperrschieber, dass Stecker an der Abzweigbox angesteckt werden können, womit zwangsläufig sichergestellt ist, dass das Kontaktieren der Schneidklemmkontakte im stromlosen Zustand erfolgt. Damit reicht für den Kontaktierungsvorgang und auch später im Betrieb eine Schutzart der Abzweigbox nach IP 54 aus.

Die EP 0734095 A1 zeigt eine elektrische Steckverbinderanordnung in Form eines Verlängerungssteckers und eines Gegenstücks. Der Verlängerungsstecker der Steckeranordnung ist als Kabelabschluss ausgebildet, der in Verlängerung des Kabelendes vollständig geschlossen ist.

Die DE 10 2020 114 330 A1 zeigt eine Anschlussdose, an welche elektrische Leiter eines Kabels mithilfe einer so genannten Anschlussklemme werkzeuglos angeschlossen werden können.

Die einzelnen Leiteranschlüsse sind bei dieser Lösung jedoch nicht abgedichtet. Hier kann Feuchtigkeit eindringen und eine in der Anschlussdose implementierte Elektronik möglicherweise schädigen.

Daher sind Anschlussdosen häufig mit Steckverbinderbuchsen ausgestattet, wie es in der DE 10 2012 014 519 B3 gezeigt ist. Eine derartige Konstruktion ist jedoch hochpreisig. Außerdem müssen Kabel mit Steckverbindern vorkonfektioniert werden, was einen hohen Zeitaufwand fordert.

Das Deutsche Patent- und Markenamt hat in der Prioritätsanmeldung zur vorliegenden Anmeldung den folgenden Stand der Technik recherchiert: DE 10 2012 014 519 B3, DE 10 2004 007 525 A1, DE 10 2020 114 330 A1, DE 20 2005 019 522 U1 und DE 11 2012 003 826 T5.

### Aufgabenstellung

Die Aufgabe der Erfindung besteht darin eine einfache und kostengünstige Kabelanschlusseinheit für eine Anschlussdose vorzuschlagen. Die Installation der Anschlussdose soll dabei werkzeuglos und zeitsparend möglich sein.

Die Aufgabe wird durch den Gegenstand der unabhängigen Ansprüche gelöst.

Vorteilhafte Ausgestaltungen der Erfindung sind in den Unteransprüchen und der folgenden Beschreibung angegeben.

Die erfindungsgemäße Kabelanschlusseinheit ist zum Anschließen an eine bzw. zur elektrischen Kontaktierung einer Anschlussdose vorgesehen. In der Regel umfasst die Anschlussdose eine Elektronik, insbesondere eine Steuerungselektronik für Stellmotoren von Lüftungsanlagen. Dazu weist die Anschlussdose eine, durch das Gehäuse der Anschlussdose geschützte, Leiterkarte auf, die elektrisch über die Kabelanschlusseinheit kontaktiert wird.

Die Kabelanschlusseinheit besteht aus einem Kabel, welches zumindest zwei, bevorzugt jedoch zumindest vier elektrische Leiter aufweist, die von einem Kabelmantel umgeben sind. Die einzelnen Leiter sind ebenfalls jeweils von einem isolierenden Leitermantel umschlossen. Man spricht in diesem Fall auch von einem mehradrigen Kabel. Bei den Leitern handelt es sich vorzugsweise um so genannte Massivleiter und nicht um Litzenleiter. Es können jedoch auch elektrische Leiter mit mehr als vier Leitern verwendet werden.

Die Kabelanschlusseinheit weist eine den Kabelmantel radial umschließenden Kabeldichtung auf. Die Kabeldichtung ist im Wesentlichen zylinderförmig, den Kabelmantel umschließend ausgebildet. Die Kabeldichtung hat eine torusartige Grundform. Vorteilhafterweise handelt es sich bei der Kabeldichtung um ein einstückiges Spritzgussteil, welches mithilfe eines Spritzgussprozesses am Kabelmantel befestigt ist. Die Kabeldichtung hat eine dichtende Funktion, stellt jedoch gleichzeitig eine Zugentlastung für das angeschlossene Kabel dar.

Die Kabelanschlusseinheit weist einen Kabelmanager auf, welcher zur Aufnahme und Fixierung der vier elektrischen Leiter des Kabels vorgesehen ist. In dem Kabelmanager liegen die vier elektrischen Leiter in einer Ebene nebeneinander. Sie sind voneinander so weit beabstandet, dass sie durch geeignete Schneidklemmen von Schneidklemmenkontakten kontaktierbar sind. Schneidklemmenkontakte weisen an einem Ende eine Schneidklemme auf, welche zur elektrischen Kontaktierung der anzuschließenden elektrischen Leiter vorgesehen ist. Am anderen Ende bestehen die Schneidklemmenkontakte beispielsweise aus einem Kontaktpin, der mit einer Leiterbahn einer Leiterkarte elektrisch kontaktiert wird.

Bei der Schneidklemmenkontaktierung werden die elektrischen Leiter zwischen zwei metallische Schneiden gedrückt, wodurch die Isolierung der Leiter durchdrungen und ein elektrischer Kontakt zwischen dem Leiter und der Schneidklemme hergestellt wird. Schneidklemmen sind beispielsweise aus der DE 11 2012 003 826 T5 bekannt und werden daher im Folgenden nicht weiter beschrieben.

Im Kabelmanager werden die elektrischen Leiter voneinander beabstandet und aufgefächert gehalten, so dass sie gleichzeitig in ein Schneidklemmenarray eindrückbar sind. Dieser Vorgang wird weiter unten noch genauer beschrieben. Von einem Schneidklemmenarray spricht man, wenn zwei oder mehr Schneidklemmenkontakte in einem Anschlussbereich als Gruppe angeordnet sind.

Vorzugsweise handelt es sich bei dem Kabelmanager um ein einstückiges Spritzgussteil, welches mithilfe eines Spritzgussprozesses an den elektrischen Leitern befestigt bzw. daran angespritzt ist. Durch eine derartige Vorkonfektionierung des Kabelmanagers sind die elektrischen Leiter in ihrer Reihenfolge zuverlässig geordnet, was die Fehleranfälligkeit bei der Installation reduziert.

Alternativ ist der Kabelmanager zweiteilig ausgebildet, wobei die beiden Teile über Rastmittel miteinander verrastbar sind. Dabei werden die Leiter zunächst in Aufnahmen des ersten Teils händisch in selbiges eingelegt. Durch die Verrastung mit dem zweiten Teil werden die eingelegten Leiter letztendlich durch den Kabelmanager fixiert. Die einzelnen Aufnahmen können farblich gekennzeichnet sein und mit den Farben der Leiterisolierungen korrelieren. Hierdurch wird die Konfektionierung des Kabelmanagers vereinfacht.

Vorzugsweise weist der Kabelmanager zwei Kontaktöffnungen auf, die jeweils im Wesentlichen rechteckig ausgebildet sind. Die Kontaktöffnungen sind für die spätere Schneidklemmenkontaktierung vorgesehen.

Vorteilhafterweise sind die Kontaktöffnungen - in Steckrichtung gesehen - hintereinander und versetzt zueinander angeordnet. Dadurch kann eine so genannte Polarisierung erzeugt werden, die eine Fehlsteckung bzw. Fehlkontaktierung des Kabelmanagers verhindert.

In einer vorteilhaften Ausgestaltung der Erfindung weist das Kabel beidseitig jeweils einen Kabelmanager und eine Kabeldichtung auf. Damit ist die Kabelanschlusseinheit zur werkzeuglosen, elektrischen Verbindung zweier Anschlussdosen geeignet.

Vorzugsweise hat das Kabel eine Länge von maximal drei Metern. Diese Länge hat sich im Bereich der Gebäudeinstallation als ausreichend herausgestellt. Die Kabel müssen nicht händisch gekürzt werden, was die Installationszeit insgesamt verringert.

Das erfindungsgemäße System besteht aus einer Anschlussdose und einer oben beschriebenen Kabelanschlusseinheit. Die Anschlussdose weist vorzugsweise eine Steuerungselektronik für einen Stellmotor auf, der insbesondere für eine Lüftungsregelung des Gebäudes vorgesehen ist.

Die Anschlussdose weist zumindest einen Aufnahmebereich für die Kabelanschlusseinheit auf, in welcher die Kabeldichtung und der Kabelmanager jeweils einlegbar sind. Hier kann bereits eine leichte Vorverrastung der entsprechenden Bauteile erfolgen, um den Installationsvorgang zu vereinfachen.

Erfindungsgemäss weist der Aufnahmebereich der Anschlussdose Schneidklemmenkontakte auf. Dabei sind jeweils zwei Schneidklemmen einer Kontaktöffnung der Kabelanschlusseinheit zugeordnet. Vorteilhafterweise weist die Anschlussdose einen schwenkbaren Deckel auf. Der Deckel hat in diesem Fall eine Doppelfunktion. Einerseits schütz er die Anschlussdose vor ein Eindringen von Medien, wie Staub und Wasser. Andererseits können die einzelnen Leiter über den Deckel zur elektrischen Kontaktierung in die Schneidklemmen der Schneidklemmenkontakte hineingedrückt werden. Über den Deckel wird hierzu eine ausreichende Hebelkraft zur Verfügung gestellt, so dass neben einer werkzeuglosen auch eine kraftschonende Installation der Anschlussdose möglich ist.

Gemäss der Erfindung weist der Kabelmanager Prüföffnungen auf. Jeweils eine Prüföffnung ist dabei einem elektrischen Leiter zugeordnet. Über die Prüföffnungen sind die einzelnen Leiter zugänglich, auch wenn diese bereits an der Anschlussdose elektrisch angeschlossen sind.

Das erfindungsgemäße System weist ein Testgerät auf, mit welchem die korrekte elektrische Kontaktierung zwischen der jeweiligen Schneidklemme und dem zugehörigen elektrischen Leiter überprüfbar ist. Dafür weist das Testgerät Kontaktpins auf, die jeweils in eine Prüföffnung des Kabelmanagers hineinsteckbar sind.

Die Kontaktpins durchstechen den Leiter und stellen so einen elektrischen Kontakt zum elektrischen Leiter her. Über eine implementierte Prüfelektronik kann eine korrekte elektrische Kontaktierung der einzelnen Leiter und damit der gesamten Anschlussdose überprüft werden. Anschließend können die Kontaktpins des Prüfgerätes einfach, nahezu Rückstandslos abgezogen werden. Das kleine Loch im Mantel des elektrischen Leiters schließt sich durch die Spannkraft des Materials automatisch und ist für die weitere Funktionsweise des Systems nicht relevant.

Nachdem die Anschlussdose an den vorgesehenen Platz, beispielsweise eine Gehäusewand, befestigt wurde, läuft das elektrische Installationsverfahren folgendermaßen ab:
Zunächst werden die Kabeldichtung und der Kabelmanager in einen Anschlussbereich der Anschlussdose eingelegt. Anschließend wird der Kabelmanager mit dem Testgerät heruntergedrückt,
wodurch die elektrischen Leiter des Kabels jeweils in eine Schneidklemme des Anschlussbereichs hineingedrückt und dadurch elektrisch kontaktiert werden. Anschließend kann eine korrekte elektrische Installation mit dem oben beschriebenen Testgerät überprüft werden.

Vorzugsweise wird ein erstes Kabelende, wie oben beschrieben, an einer ersten Anschlussdose angeschlossen und ein zweites Ende des Kabels analog wird an einer zweiten Anschlussdose angeschlossen. Mit einer erfindungsgemäßen Anschlussdose und einer erfindungsgemäßen Kabelanschlusseinheit kann eine Gebäudeinstallation schnell und effektiv erfolgen.

Die Anschlusseinheit kann beidseitig über Kabelmanager verfügen, so dass zwei benachbarte Anschlussdosen über eine Anschlusseinheit miteinander elektrisch kontaktiert werden können. Die Anschlussdosen können jeweils mehrere Kontaktierungsaufnahmen, beispielsweise zwei Kontaktierungsaufnahmen, für Anschlusseinheiten aufweisen.

### Ausführungsbeispiel

Ein Ausführungsbeispiel der Erfindung ist in den Zeichnungen dargestellt und wird im Folgenden näher erläutert. Es zeigen:
- Fig. 1: eine perspektivische Darstellung zweier Kabelanschlusseinheiten und eine dazugehörige erfindungsgemäße Anschlussdose,
- Fig. 2: eine perspektivische Darstellung eines Kabels mit freien elektrischen Leitern im Endbereich und einer davor angespritzten Kabeldichtung,
- Fig. 3: eine perspektivische Darstellung eines Kabels mit einem Kabelmanager,
- Fig. 4: eine perspektivische Darstellung einer Leiterkarte mit einer Kabelanschlusseinheit,
- Fig. 5: eine perspektivische Darstellung eines Leiterkartensteckverbinders,
- Fig. 6: eine perspektivische Darstellung eines zweiteiligen Kabelmanagers in einem unverrasteten Zustand,
- Fig. 7: eine perspektivische Darstellung eines zweiteiligen Kabelmanagers in einem verrasteten Zustand,
- Fig. 8: eine perspektivische Darstellung eines weiteren Ausführungsbeispiels eines zweiteiligen Kabelmanagers mit angeformter Kabeldichtung in einem unverrasteten Zustand und
- Fig. 9: eine perspektivische Darstellung eines erfindungsgemässen zweiteiligen Kabelmanagers mit angeformter Kabeldichtung in einem verrasteten Zustand.
- Fig. 10: eine schematische Darstellung eines Verfahrens zum Anschließen einer Kabelanschlusseinheit.
- Fig. 11: eine perspektivische Darstellung eines Testgeräts.

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein. Angaben wie links und rechts sind auf die Perspektive der jeweiligen Figur bezogen.

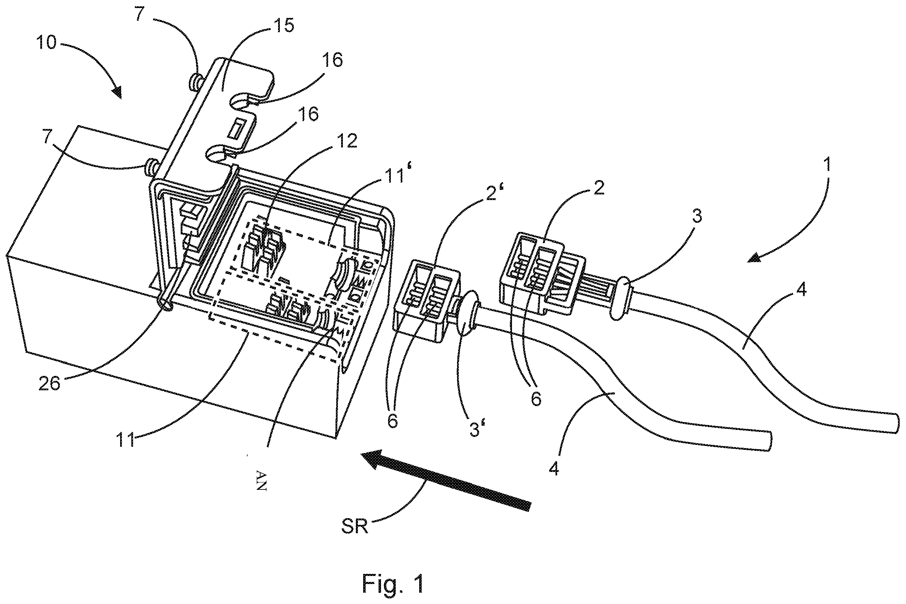

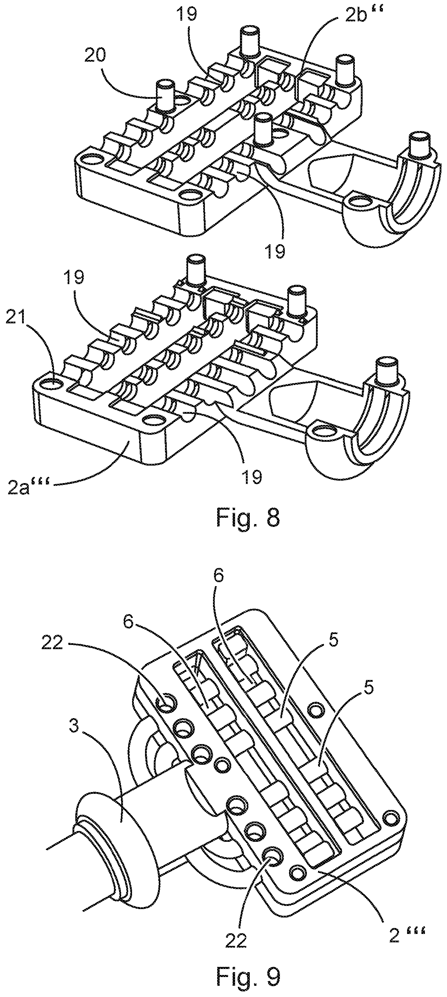

In Figur 1 sind zwei Varianten von Kabelanschlusseinheiten gezeigt. Die Kabelanschlusseinheit besteht aus einem Kabel 4 an dessen einem Kabelende die elektrischen Leiter 5 vom Kabelmantel befreit worden sind. Erfindungsgemäß wird ein mindestens zweiadriges Kabel verwendet. Es können aber auch mehr als zwei Leiter, beispielsweise sechs Leiter 5, wie beispielsweise in Figur 8 gezeigt, vorhanden sein.

Vor den kabelmantelbefreiten Leitern 5 ist eine angespritzte Kabeldichtung 3 vorgesehen. Die einzelnen Leiter 5 werden in einem Kabelmanager 2 aufgefächert fixiert. Der Kabelmanager 2 weist zwei - in Steckrichtung SR gesehen - hintereinander, aber parallel zur Steckrichtung SR versetzt zueinander angeordnete Kontaktöffnungen 6 auf.

Die Anschlussdose 10 ist in Figur 1 in ihrem geöffneten Zustand dargestellt. Die Anschlussdose 10 weist einen Anschlussbereich 11, 11' auf, der in Figur 1 durch ein gestricheltes Rechtseck gekennzeichnet bzw. hervorgehoben ist. Im Anschlussbereich 11, 11' ist ein Leiterkartensteckverbinder 12 angeordnet. Der Leiterkartensteckverbinder 12 weist Schneidklemmenkontakte mit Kontaktpins 9 für die Leiterkarte 17 und Schneidklemmen 14 für die elektrischen Leiter 5 auf. Außerdem befindet sich im Anschlussbereich 11, 11' eine Aufnahme AN, in welche die Kabeldichtung 3 formschlüssig eingelegt werden kann. Die Anschlussdose 10 weist einen Deckel 15 auf, der für den geschlossenen Zustand Ausnehmungen 16 für das Kabel 4 aufweist. Der Deckel 15 kann über Schrauben 7 am Gehäuse der Anschlussdose 10 festgeschraubt werden.

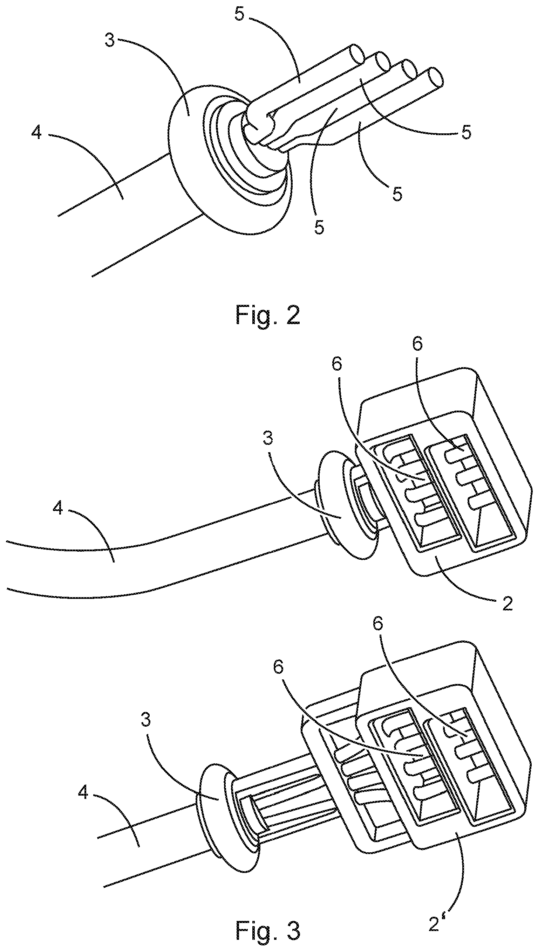

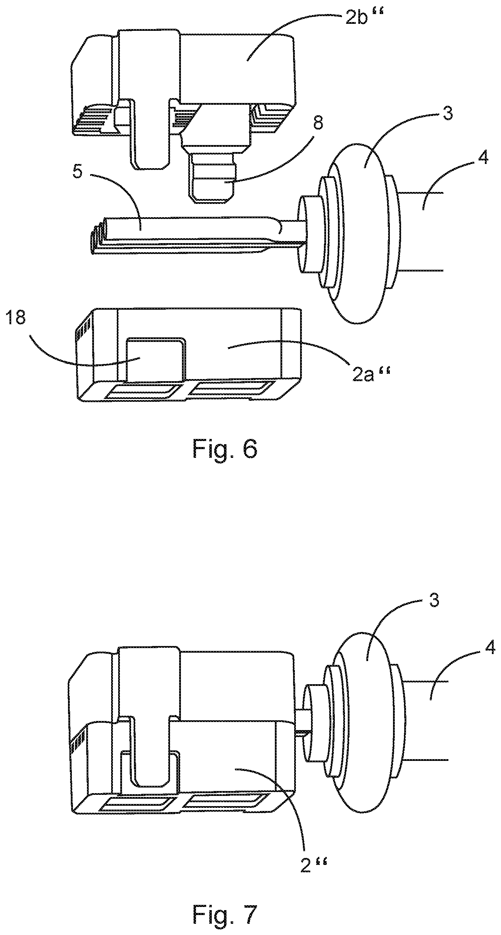

Der vom Kabelmantel befreite Endabschnitt eines Kabels 4 ist in Figur 2 zu sehen. Hier handelt es sich um ein vieradriges Kabel mit entsprechend vier elektrischen Leitern 5, die jeweils einen Isoliermantel in einer anderen Farbe aufweisen. Die Farben sind weltweit genormt. So steht beispielsweise eine grüngelbe Farbkennzeichnung für das Erdpotential. Die Leiter 5 werden wie in Figur 2 dargestellt aufgefächert. Dann können diese beispielsweise in eine Spritzgussform eingelegt werden und in einem Spritzgussverfahren mit einem Kabelmanager 2, 2' versehen werden, wie er beispielsweise in Figur 3 gezeigt ist. Alternativ können zweiteilige Kabelmanager 2", 2‴ verwendet werden, wie sie in den Figuren 6 und 8 dargestellt sind.

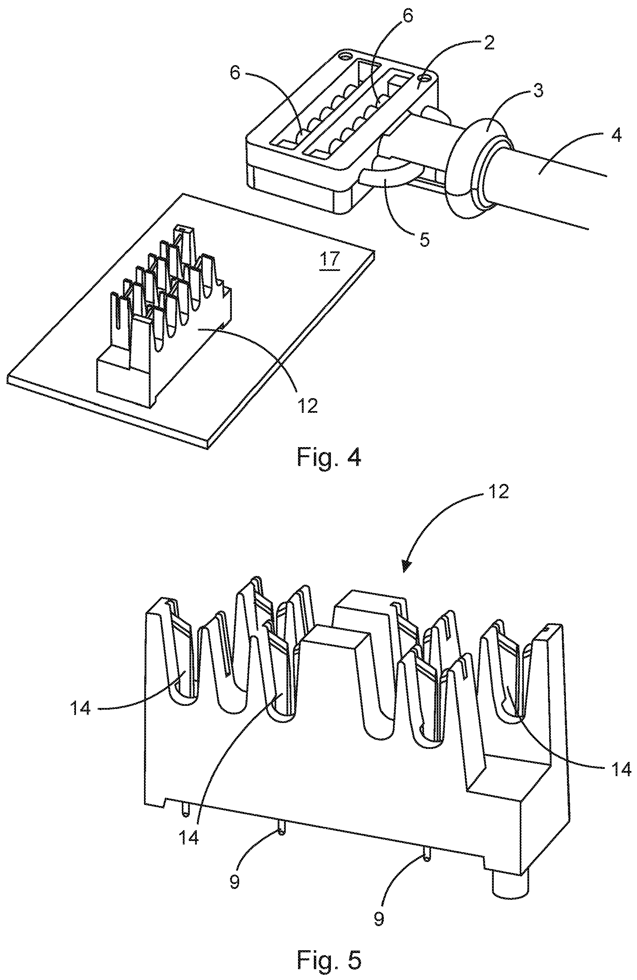

Die Anschlussdose 10 weist eine Leiterkarte 17 mit Steuerungselektronik (nicht dargestellt) auf. Die Leiterkarte 17 ist rein schematisch in Figur 4 zu sehen. Auf der Leiterkarte 17 ist der Leiterkartensteckverbinder 12 mithilfe von Kontaktpins 9 gesteckt. Die Kontaktpins 9 sind jeweils mit Leiterbahnen der Leiterkarte 17 elektrisch verbunden. Der Kabelanschlussbereich des Leiterkartensteckverbinders 12 wird durch die Schneidklemmen 14 der Schneidklemmenkontakte gebildet.

Wenn die Kabelanschlusseinheit 1 passgenau im Anschlussbereich 11 der Anschlussdose 10 positioniert bzw. eingelegt ist, wird der Deckel 15 der Anschlussdose 10 geschlossen. Im Inneren des Deckels sind Stege 26 angeformt. Hierdurch werden die einzelnen Leiter 5 des Kabels 4 in die zugehörigen Schneidklemmen 14 des Leiterkartensteckverbinders 12 (Figur 5) eingedrückt.

In den Figuren 6 und 7 ist eine erste zweiteilige Variante eines erfindungsgemäßen Kabelmanagers 2" dargestellt. Die beiden Teile 2a", 2b" können mithilfe von Rastarmen 8 eines Teils 2b" und dazu passenden Ausnehmungen 18 des anderen Teils 2a" miteinander verrastet werden. Die einzelnen Leiter 5 werden zuvor in einem der beiden Teile 2a", 2b" passend aufgefächert eingelegt.

Die Figuren 8 und 9 zeigen eine weitere zweiteilige Variante eines Kabelmanagers 2‴. Hier werden die beiden Teile 2a‴, 2b‴ mithilfe von Noppen 20 und dazu passenden Noppenöffnungen 21 miteinander verrastet. Die elektrischen Leiter 5 werden zuvor in dafür vorgesehene Leiteraufnahmen 19 eingelegt. Die hier gezeigte Variante des Kabelmanagers 2‴ ist weiterhin mit der Kabeldichtung 3 ausgestattet, so dass hierfür auch keine vorherige Umspritzung erfolgen muss.

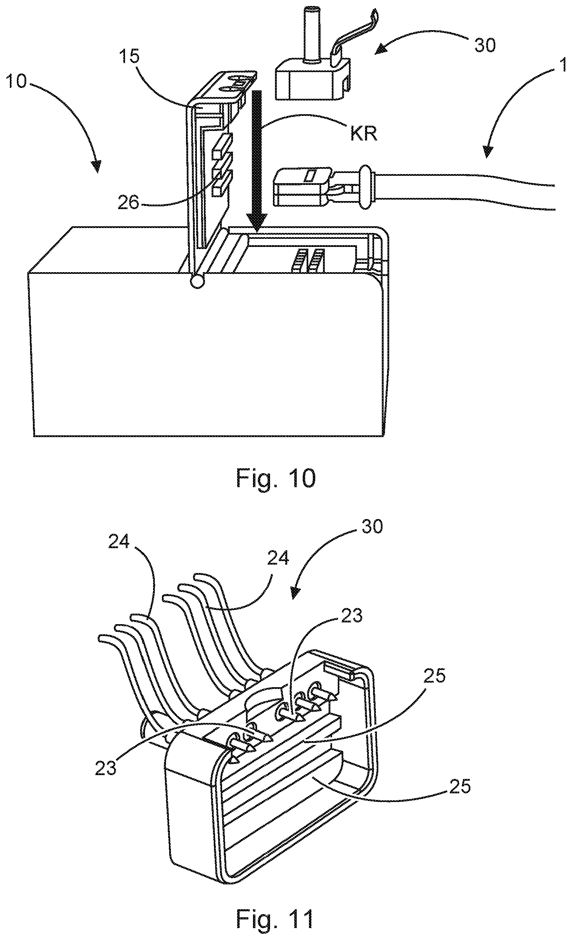

Im Kabelmanager 2‴ sind Prüföffnungen 22 vorgesehen. Jeweils eine Prüföffnung ist einem elektrischen Leiter 5 des Kabels 4 zugeordnet. In Figur 11 ist ein Testgerät 30 gezeigt, welches mit Kontaktpins 23 versehen ist, die in die Prüföffnungen 22 einsteckbar sind. Hierdurch werden die elektrischen Leiter 5 im Kabelmanager 2 elektrisch kontaktiert. Die Kontaktpins 23 sind am anderen Ende mit Kontrollleitern 24 verbunden, die mit einer Prüfelektronik (nicht gezeigt) gekoppelt sind. Hierüber kann geprüft werden, ob die elektrische Kontaktierung der elektrischen Leiter 5 an der Anschlussdose 10 korrekt erfolgt ist.

In Figur 10 ist ein erfindungsgemässer Kontaktierungsprozess der Kabelanschlusseinheit 1 an die Anschlussdose 10 zu sehen. Das Testgerät weist innenseitig zwei Stege 25 auf, welche passgenau in die Kontaktöffnungen 6 des Kabelmanagers 2, 2', 2", 2‴ einführbar sind. Über das Testgerät 30 wird die Anschlusseinheit 1 senkrecht - in Kontaktierungsrichtung KR - in den Anschlussbereich 11 der Anschlussdose 10 gedrückt. Dabei wird über das Testgerät 30 die Kraft aufgebaut, die notwendig ist, die elektrischen Leiter 5 in die Schneidklemmen 14 einzudrücken. Bei erfolgreicher Kontaktierung wird vom Testgerät 30 ein entsprechendes Signal, beispielsweise ein grüne LED, aktiviert. Danach wird das Testgerät 30 entfernt und der Deckel 15 der Anschlussdose 10 kann verschlossen werden.

Die Anschlusseinheit 1 kann beidseitig über Kabelmanager 2, 2', 2", 2‴ verfügen, so dass zwei benachbarte Anschlussdosen 10 über eine Anschlusseinheit miteinander elektrisch kontaktiert werden können.

Auch wenn in den Figuren verschiedene Aspekte oder Merkmale der Erfindung jeweils in Kombination gezeigt sind, ist für den Fachmann - soweit nicht anders angegeben - ersichtlich, dass die dargestellten und diskutierten Kombinationen nicht die einzig möglichen sind. Insbesondere können einander entsprechende Einheiten oder Merkmalskomplexe aus unterschiedlichen Ausführungsbeispielen miteinander ausgetauscht werden.

### Bezugszeichenliste

- 1: Kabelanschlusseinheit
- 2: Kabelmanager
- 3: Kabeldichtung
- 4: Kabel
- 5: Elektrischer Leiter
- 6: Kontaktöffnung
- 7: Schraube
- 8: Rastarm
- 9: Kontaktpin
- 10: Anschlussdose
- 11: Anschlussbereich
- 12: Leiterkartensteckverbinder

- 14: Schneidklemme
- 15: Deckel
- 16: Ausnehmung für das Kabel 4
- 17: Leiterkarte
- 18: Ausnehmung
- 19: Leiteraufnahme
- 20: Noppe
- 21: Noppenöffnung
- 22: Prüföffnung
- 23: Kontaktpin des Testgeräts 30
- 24: Kontrollleiter
- 25: Steg
- 26: Steg
- 28: Testgerät
- SR: Steckrichtung
- KR: Kontaktierungsrichtung

## Patentansprüche

1. Kabelanschlusseinheit (1) für eine Anschlussdose (10), bestehend aus
- einem Kabel (4), welches zumindest zwei, bevorzugt jedoch vier elektrische Leiter (5) aufweist, die von einem Kabelmantel umgeben sind,
- einer den Kabelmantel radial umschließenden Kabeldichtung (3) und
- einem Kabelmanager (2, 2', 2", 2‴), in welchem die zumindest zwei, bevorzugt vier elektrischen Leiter (5) aufgefächert gehalten sind
**dadurch gekennzeichnet, dass**
der Kabelmanager (2‴) Prüföffnungen (22) aufweist, wobei jeweils eine Prüföffnung (22) einem elektrischen Leiter (5) zugeordnet ist.

2. Kabelanschlusseinheit (1) nach Anspruch 1
**dadurch gekennzeichnet, dass**
die Kabeldichtung (3) ein einstückiges Spritzgussteil ist und mithilfe eines Spritzgussprozesses am Kabelmantel befestigt ist.

3. Kabelanschlusseinheit nach einem der vorstehenden Ansprüche **dadurch gekennzeichnet, dass**
der Kabelmanager (2, 2') ein einstückiges Spritzgussteil ist und mithilfe eines Spritzgussprozesses an den elektrischen Leitern (5) befestigt ist.

4. Kabelanschlusseinheit (1) nach einem der vorstehenden Ansprüche 1 bis 2
**dadurch gekennzeichnet, dass**
der Kabelmanager (2", 2‴) zweiteilig ausgebildet ist, wobei die beiden Teile (2a, 2b) über Rastmittel miteinander verrastbar sind.

5. Kabelanschlusseinheit (1) nach einem der vorstehenden Ansprüche
**dadurch gekennzeichnet, dass**
der Kabelmanager (2, 2', 2", 2‴) zwei Kontaktöffnungen (6) aufweist, die jeweils im Wesentlichen einen rechteckigen Querschnitt aufweisen.

6. Kabelanschlusseinheit (1) nach vorstehendem Anspruch
**dadurch gekennzeichnet, dass**
die Kontaktöffnungen (6) in Steckrichtung (SR) hintereinander und versetzt zueinander angeordnet sind.

7. Kabelanschlusseinheit nach einem der vorstehenden Ansprüche **dadurch gekennzeichnet, dass**
das Kabel (4) beidseitig jeweils einen Kabelmanager (2, 2', 2", 2‴) und eine Kabeldichtung (3) aufweist.

8. Kabelanschlusseinheit nach einem der vorstehenden Ansprüche **dadurch gekennzeichnet, dass**
das Kabel (4) eine Länge von maximal drei Metern aufweist.

9. System aus einer Anschlussdose (10) und einer Kabelanschlusseinheit (1) nach einem der vorstehenden Ansprüche,
wobei die Anschlussdose (10) zumindest einen Aufnahmebereich (11) für die Kabelanschlusseinheit (1) aufweist, in welcher die Kabeldichtung (3) und der Kabelmanager (2, 2', 2", 2‴) jeweils einlegbar sind
**dadurch gekennzeichnet, dass**
der Aufnahmebereich (11) der Anschlussdose (10) Schneidklemmenkontakte (14) aufweist und
dass das System ein Testgerät (30) aufweist, mit welchem die korrekte elektrische Kontaktierung zwischen dem jeweiligen Schneidklemmenkontakt (14) und dem zugehörigen elektrischen Leiter (5) überprüfbar ist.

10. System nach vorstehendem Anspruch und Anspruch 5
**dadurch gekennzeichnet, dass**
jeweils zumindest zwei Schneidklemmenkontakt (14) zu einer Kontaktöffnung (6) der Kabelanschlusseinheit (1) korrelieren.

11. System nach einem der drei vorstehenden Ansprüche
**dadurch gekennzeichnet, dass**
die Anschlussdose (10) einen schwenkbaren Deckel (15) aufweist.

12. System nach vorstehendem Anspruch **dadurch gekennzeichnet, dass**
das Testgerät (30) Kontaktpins (23) aufweist, die jeweils in eine Prüföffnung (22) des Kabelmanagers (2‴) hineinsteckbar sind.

13. Verfahren zum Anschließen einer Kabelanschlusseinheit (1) nach einem der vorstehenden Ansprüche 1 bis 8 an eine Anschlussdose (10) aus dem System nach einem der vorstehenden Ansprüche 9-12,
a) wobei die Kabeldichtung (3) und der Kabelmanager (2, 2', 2", 2‴) in einen Anschlussbereich (11) der Anschlussdose (10) eingelegt werden,
b) der Kabelmanager (2‴) mit dem Testgerät (30) heruntergedrückt wird,
c) wodurch die elektrischen Leiter des Kabels (5) jeweils in einen Schneidklemmenkontakt (14) des Anschlussbereichs (11) hineingedrückt und dadurch elektrisch kontaktiert werden.

14. Verfahren zum Anschließen einer Kabelanschlusseinheit (1) nach vorstehendem Anspruch **dadurch gekennzeichnet, dass**
ein erstes Ende des Kabels (4) an einer ersten Anschlussdose (10) angeschlossen wird und ein zweites Ende des Kabels (4) an einer zweiten Anschlussdose (10) angeschlossen wird.

## Claims

1. Cable connection unit (1) for a connection box (10), consisting of
- a cable (4) which has at least two but preferably four electrical conductors (5) which are surrounded by a cable sheath,
- a cable seal (3) radially enclosing the cable sheath, and
- a cable manager (2, 2', 2'', 2‴) in which the at least two, preferably four, electrical conductors (5) are held fanned out,
**characterized in that**
the cable manager (2‴) has testing openings (22), wherein each testing opening (22) is associated with one electrical conductor (5).

2. Cable connection unit (1) according to Claim 1, **characterized in that**
the cable seal (3) is a one-piece injection-moulded part and is fastened to the cable sheath by means of an injection-moulding process.

3. Cable connection unit according to either of the preceding claims,
**characterized in that**
the cable manager (2, 2') is a one-piece injection-moulded part and is fastened to the electrical conductors (5) by means of an injection-moulding process.

4. Cable connection unit (1) according to either of the preceding Claims 1 and 2,
**characterized in that**
the cable manager (2", 2‴) has a two-part design, wherein the two parts (2a, 2b) can be interlocked with each other via latching means.

5. Cable connection unit (1) according to one of the preceding claims,
**characterized in that**
the cable manager (2, 2', 2", 2‴) has two contact openings (6) which each have an essentially rectangular cross-section.

6. Cable connection unit (1) according to the preceding claim,
**characterized in that**
the contact openings (6) are arranged, in the plugging direction (SR), one behind the other and offset relative to one another.

7. Cable connection unit according to one of the preceding claims,
**characterized in that**
the cable (4) has in each case one cable manager (2, 2', 2'', 2‴) and one cable seal (3) on both sides.

8. Cable connection unit according to one of the preceding claims,
**characterized in that**
the cable (4) has a length of no more than three metres.

9. System consisting of a connection box (10) and a cable connection unit (1) according to one of the preceding claims,
wherein the connection box (10) has at least one socket region (11) for the cable connection unit (1) in which the cable seal (3) and the cable manager (2, 2', 2'', 2‴) can each be inserted,
**characterized in that**
the socket region (11) of the connection box (10) has insulation displacement contacts (14), and
**in that** the system has a test device (30) by means of which the correct electrical contacting between the respective insulation displacement contact (14) and the associated electrical conductor (5) can be checked.

10. System according to the preceding claim and Claim 5,
**characterized in that**
in each case at least two insulation displacement contacts (14) correlate with one contact opening (6) of the cable connection unit (1).

11. System according to one of the three preceding claims,
**characterized in that**
the connection box (10) has a hinged cover (15).

12. System according to the preceding claim, **characterized in that**
the test device (30) has contact pins (23) which can each be pushed into a testing opening (22) of the cable manager (2‴).

13. Method for connecting a cable connection unit (1) according to one of the preceding Claims 1 to 8 to a connection box (10) from the system according to one of the preceding Claims 9-12,
a) wherein the cable seal (3) and the cable manager (2, 2', 2'', 2‴) are inserted into a connection region (11) of the connection box (10),
b) the cable manager (2''') is pushed down with the test device (30),
c) as a result of which the electrical conductors of the cable (5) are each pushed into an insulation displacement contact (14) of the connection region (11) and consequently electrically contacted.

14. Method for connecting a cable connection unit (1) according to the preceding claim,
**characterized in that**
a first end of the cable (4) is connected to a first connection box (10) and a second end of the cable (4) is connected to a second connection box (10).

## Revendications

1. Unité de jonction de câble (1) pour une boîte de jonction (10) consistant en
- un câble (4), qui comporte au moins deux, mais de préférence quatre conducteurs électriques (5), qui sont entourés par une gaine de câble,
- un presse-étoupe de câble (3), qui entoure radialement la gaine de câble et
- un gestionnaire de câble (2, 2', 2", 2‴), dans lequel les au moins deux, de préférence quatre, conducteurs électriques (5) sont maintenus en éventail, **caractérisée en ce que**
le gestionnaire de câble (2‴) présente des ouvertures de test (22), une ouverture de test (22) étant respectivement associée à un conducteur électrique (5).

2. Unité de jonction de câble (1) selon la revendication 1,
**caractérisée en ce que**
le presse-étoupe de câble (3) est une pièce moulée par injection d'un seul tenant et est fixé à la gaine de câble à l'aide d'un processus de moulage par injection.

3. Unité de jonction de câble selon l'une quelconque des revendications précédentes,
**caractérisée en ce que**
le gestionnaire de câble (2, 2') est une pièce moulée par injection d'un seul tenant et est fixé aux conducteurs électriques (5) à l'aide d'un processus de moulage par injection.

4. Unité de jonction de câble (1) selon l'une quelconque des revendications 1 à 2,
**caractérisée en ce que**
le gestionnaire de câble (2", 2‴) est formé en deux parties, les deux parties (2a, 2b) pouvant être encliquetées entre elles par l'intermédiaire de moyens d'encliquetage.

5. Unité de jonction de câble (1) selon l'une quelconque des revendications précédentes,
**caractérisée en ce que**
le gestionnaire de câble (2, 2', 2", 2‴) présente deux ouvertures de contact (6), qui présentent chacune une section transversale sensiblement rectangulaire.

6. Unité de jonction de câble (1) selon la revendication précédente,
**caractérisée en ce que**
les ouvertures de contact (6) sont disposées les unes après les autres et sont décalées les unes par rapport aux autre dans la direction d'enfichage (SR).

7. Unité de jonction de câble selon l'une quelconque des revendications précédentes,
**caractérisée en ce que**
le câble (4) comporte respectivement, des deux côtés, un gestionnaire de câble (2, 2', 2", 2‴) et un presse-étoupe de câble (3).

8. Unité de jonction de câble selon l'une quelconque des revendications précédentes,
**caractérisée en ce que**
le câble (4) a une longueur maximale de trois mètres.

9. Système constitué d'une boîte de jonction (10) et d'une unité de jonction de câble (1) selon l'une quelconque des revendications précédentes,
dans lequel la boîte de jonction (10) présente au moins une zone de réception (11) pour l'unité de jonction de câble (1), dans laquelle peuvent respectivement être insérés le presse-étoupe de câble (3) et le gestionnaire de câble (2, 2', 2", 2‴),
**caractérisé en ce que**
la zone de réception (11) de la boîte de jonction (10) comporte des contacts autodénudants (14) et
**en ce que** le système comporte un appareil de test (30) au moyen duquel la mise en contact électrique correcte entre le contact autodénudant (14) respectif et le conducteur électrique (5) correspondant est vérifiable.

10. Système selon la revendication précédente et la revendication 5,
**caractérisé en ce que**
au moins deux contacts autodénudants (14) sont respectivement en corrélation avec une ouverture de contact (6) de l'unité de jonction de câble (1).

11. Système selon l'une des trois revendications précédentes,
**caractérisé en ce que**
la boîte de jonction (10) comporte un couvercle pivotant (15).

12. Système selon la revendication précédente, **caractérisé en ce que**
l'appareil de test (30) comporte des broches de contact (23) pouvant respectivement être insérées dans une ouverture de test (22) du gestionnaire de câble (2"').

13. Procédé de raccordement d'une unité de jonction de câble (1) selon l'une quelconque des revendications 1 à 8 précédentes à une boîte de jonction (10) en sortie du système selon l'une quelconque des revendications 9 à 12 précédentes,
a) le presse-étoupe de câble (3) et le gestionnaire de câble (2, 2', 2", 2"') étant insérés dans une zone de jonction (11) de la boîte de jonction (10),
b) le gestionnaire de câble (2"') est enfoncé au moyen de l'appareil de test (30),
c) d'où il résulte que les conducteurs électriques du câble (5) sont respectivement enfoncés dans un contact autodénudant (14) de la zone de jonction (11) et ainsi mis en contact électrique.

14. Procédé de raccordement d'une unité de jonction de câble (1) selon la revendication précédente, **caractérisé en ce que**
une première extrémité du câble (4) est raccordée à une première boîte de jonction (10) et une deuxième extrémité du câble (4) est raccordée à une deuxième boîte de jonction (10).
